Europäisches Patentamt

European Patent Office

Office européen des brevets

(11) Veröffentlichungsnummer: **0 400 184**
**A1**

## (12) EUROPÄISCHE PATENTANMELDUNG

(21) Anmeldenummer: 89109871.7

(22) Anmeldetag: 31.05.89

(51) Int. Cl.5: **G11C 29/00, G11C 11/40**

(43) Veröffentlichungstag der Anmeldung:
**05.12.90 Patentblatt 90/49**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**D-8000 München 2(DE)**

(72) Erfinder: **Kantz, Dieter, Dipl.-Ing.**
**Heiglhofstrasse 45**
**D-8000 München 70(DE)**

(54) **Integrierter Halbleiter-speicher vom Typ DRAM und Verfahren zu seinem Betrieb.**

(57) Den Speicherzellen MC des Halbleiterspeichers sind in einem Testbetrieb über externe Bitleitungen XB, $\overline{XB}$ frei wählbare elektrische Potentiale VXN,VXP als zu speichernde Daten zuführbar. Damit ist ein Variieren der in den Halbleiterspeicher einzuschreibenden Daten gegenüber einem Normalbetrieb möglich, ohne die sonstigen elektrischen und zeitlichen Verhältnisse des Halbleiterspeichers zu beeinflussen. Dies ermöglicht eine gezielte Analyse der Bewerterschaltungen AMPL und ein Ermitteln ihrer Arbeitsbereiche.

EP 0 400 184 A1

FIG 2

## Integrierter Halbleiterspeicher vom Typ DRAM und Verfahren zu seinem Betrieb

Die Erfindung betrifft einen integrierten Halbleiterspeicher nach dem Oberbegriff des Patentanspruches 1 sowie ein Verfahren zu seinem Betrieb nach dem Oberbegriff des Patentanspruches 11.

Gattungsgemäße integrierte Halbleiterspeicher sind beispielsweise aus EP-A 0 056 434 und aus "IEEE Journal of Solid-State Circuits", Vol. SC-20, No. 5, October 1985, Seiten 903 bis 908 bekannt. Beiden Literaturstellen ist gemeinsam, daß ihre Bewerterschaltungen als dynamische Flip-Flops mit kreuzgekoppelten Transistoren gestaltet sind.

Für den wirtschaftlichen Erfolg integrierter Halbleiterspeicher sind ihre technischen Eigenschaften ein entscheidender Punkt. Von zentraler Bedeutung sind dabei der Arbeitsbereich der Bewerterschaltungen sowie die Minimalwerte der Lesesignale, die die Bewerterschaltungen gerade noch fehlerfrei verarbeiten können. Diese Parameter sind stark abhängig von einer technisch gleichen Wirkung und Symmetrie der verwendeten Transistoren. Sie werden üblicherweise im Entwicklungsstadium sowie bei Qualifizierungstests mittels Variation von Betriebsspannungen so wie von Pegeln und Timing von Eingangssignalen gewonnen. Diese Methode verändert jedoch das Zeitverhalten der speicherintern ablaufenden Signale sowie die Potentialverhältnisse im gesamten Halbleiterspeicher, so daß die Meßergebnisse nicht mehr eindeutig einzelnen Fehlerquellen in den Bewerterschaltungen und deren Arbeitsbereichen zuzuordnen sind.

Aufgabe der vorliegenden Erfindung ist es, einen gattungsgemäßen Halbleiterspeicher so weiterzubilden, daß in einem Testbetrieb eine Ermittlung der Arbeitsbereiche sowie einzelner Fehlerquellen der Bewerterschaltungen möglich ist, ohne dabei, verglichen mit einem Normalbetrieb, wenigstens die Mehrzahl der sonstigen elektrischen und zeitlichen Verhältnisse des Halbleiterspeichers selbst zu beeinflussen. Weiterhin ist es Aufgabe, ein geeignetes Betriebsverfahren anzugeben, das die obengenannten Ermittlungen ermöglicht.

Diese Aufgabe wird gelöst durch die kennzeichnenden Merkmale der Patentansprüche 1 und 11. Vorteilhafte Aus- und Weiterbildungen sind in Unteransprüchen gekennzeichnet.

Die Erfindung wird im folgenden anhand von FIG näher erläutert.

Es zeigen, jeweils ausschnittsweise:

FIG 1 einen bekannten Halbleiterspeicher,

FIG 2 den erfindungsgemäßen Halbleiterspeicher.

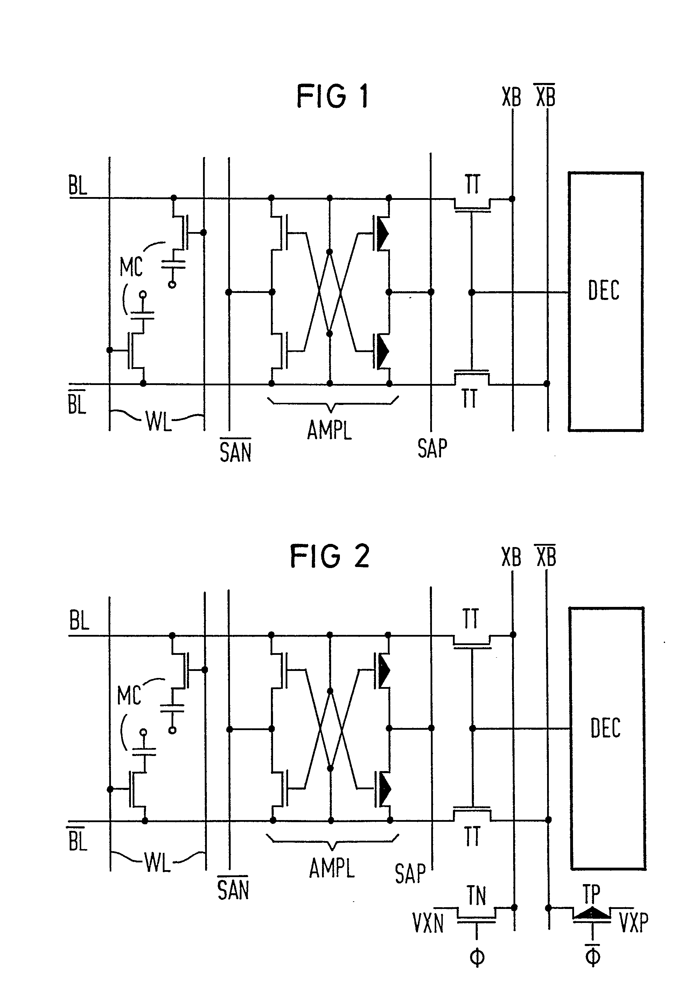

FIG 1 zeigt ausschnittsweise einen bekannten integrierten Halbleiterspeicher mit Speicherzellen MC, internen Bitleitungen BL und $\overline{BL}$ (allgemein als Referenzbitleitung bezeichnet), Wortleitungen WL, einer Bewerterschaltung AMPL, Transfertransistoren TT (auch als Bitschalter bezeichnet) mit Adreßdekoder DEC sowie externe Bitleitungen XB, $\overline{XB}$. Weiterhin sind zwei Steuersignale $\overline{SAN}$ und SAP dargestellt, die insbesondere in einem Auslesemodus einem Aktivieren der Bewerterschaltungen AMPL dienen.

Die in FIG 2 dargestellte Erfindung weist gegenüber dem bekannten Halbleiterspeicher zusätzlich Mittel TN,TP auf, mittels derer wertemäßig frei wählbare elektrische Potentiale VXN,VXP mit den externen Bitleitungen XB, $\overline{XB}$ verbindbar sind. Die Mittel TN, TP sind in einem Normalbetrieb ohne Einfluß auf den Halbleiterspeicher. In einem Testbetrieb, der beispielsweise der Ermittlung der eingangs genannten Parameter dient, werden die frei wählbaren elektrischen Potentiale VXN,VXP über die externen Bitleitungen XB, $\overline{XB}$ und die internen Bitleitungen BL, $\overline{BL}$ auf die Speicherzellen MC gegeben und dort als Datum eingespeichert.

Die Mittel TN,TP sind vorzugsweise Transistoren, insbesondere vom zueinander komplementären Typ. Es ist vorteilhaft, daß die Mittel durch ein Taktsignal $\emptyset$ steuerbar sind. Dies ermöglicht ein Verbinden der Mittel mit den externen Bitleitungen XB, $\overline{XB}$ im Testbetrieb und ein Aufheben der Verbindung im Normalbetrieb. Dabei ist es günstig, wenn anstelle eines einzigen Taktsignales $\emptyset$ zwei zueinander komplementäre Taktsignale $\emptyset$, $\overline{\emptyset}$ vorgesehen sind.

Wie bereits ausgeführt, werden die wertemäßig frei wählbaren elektrischen Potentiale VXN,VXP im Testbetrieb als in die Speicherzellen MC einzuspeichernde Daten verwendet. Im Normalbetrieb weisen, wie allgemein bekannt, einzuspeichernde Daten logische Pegel auf (log. 0, log. 1), deren Werte bezüglich des gesamten Halbleiterspeichers optimiert sind. Im Testbetrieb hingegen ist es möglich, diese logischen Pegel ohne Veränderungen sonstiger elektrischer und zeitlicher Verhältnisse im Halbleiterspeicher durch Variation der Werte der frei wählbaren elektrischen Potentiale VXN,VXP bezüglich der im Normalbetrieb üblichen logischen Pegel log. 0, log. 1 zu modifizieren. Daten, die mit gegenüber dem Normalbetrieb modifizierten Pegeln eingeschrieben sind, erzeugen bei einem nachfolgenden Auslesen jedoch Lesesignale auf den Bitleitungen BL, $\overline{BL}$, die gegenüber Lesesignalen von Daten, die im Normalbetrieb eingeschrieben worden waren, wertemäßig unterschiedlich sind. Die Erfindung ermöglicht demzufolge mittelbar, den Bewerterschaltungen AMPL eines Halbleiterspeichers gezielt Lesesignale mit unterschiedlichen Pegelwerten zuzuführen und somit die Arbeitsbereiche der Bewerterschaltungen AMPL zu ermitteln, ohne dadurch die sonstigen elektrischen und zeitlichen Verhältnisse der Signale und Potentiale im Halbleiterspeicher gegenüber den Verhältnissen im Normalbetrieb zu verändern.

Die Erfindung ermöglicht beispielsweise folgendes vorteilhafte Einschreibverfahren (alle Potentialwerte sind auf Masse bezogen): Als Wert des einen frei wählbaren Potentials VXN werden 0,2 V gewählt. Als Wert des anderen frei wählbaren Potentials VXP werden 4,5 V gewählt. Der im entsprechenden Normalbetrieb verwendete Potentialwert von log. 0 sei mit 0 V (entsprechend dem Massepotential VSS des Halbleiterspeichers) angenommen und der im entsprechenden Normalbetrieb verwendete Potentialwert von log. 1 sei mit 5 V (entsprechend dem Versorgungspotential VDD des Halbleiterspeichers) angenommen. Wenn nun im Testbetrieb in eine mit der Bitleitung BL verbundene, über eine Wortleitung WL adressierte Speicherzelle MG das Datum "log. 0" eingeschrieben werden soll, so wird das eine elektrische Potential VXN, das vereinbarungsgemäß 0,2 V beträgt, über Aktivieren des Taktsignales Ø (d.h. also, der eine Transistor TN wird elektrisch leitend geschaltet) an die eine externe Bitleitung XB angelegt und mittels eines durch den Adreßdekoder DEC leitend geschalteten Transfertransistors TT an die interne Bitleitung BL angelegt. Durch Adressieren der entsprechenden Speicherzelle MC ist die "log. 0" mit einem Wert von 0,2 V einschreibbar. Entsprechendes gilt für das Einschreiben einer log. 1: Das andere elektrische Potential VXP wird zu 4,5 V gewählt. Es wird mittels Aktivieren des Taktsignales Ø̄ (das einen komplementären Verlauf bezüglich des Taktsignales Ø aufweist, was wegen der gewählten unterschiedlichen Kanaltypen der Transistoren TN,TP günstig ist) auf die andere externe Bitleitung X̄B̄ gegeben und gelangt von dort über die andere interne Bitleitung B̄L̄ in die entsprechende adressierte Speicherzelle MC.

Die Erfindung ermöglicht, daß in eine erste Hälfte der Speicherzellen MC Daten mit dem einen elektrischen Potential VXN einschreibbar sind und daß in die zweite Hälfte der Speicherzellen MG Daten mit dem anderen elektrischen Potential VXP einschreibbar sind. Es ist somit nicht möglich, in jede beliebige Speicherzelle MC sowohl Daten mit dem einen elektrischen Potential VXN wie auch Daten mit dem anderen elektrischen Potential VXP einzuschreiben. Dies ist zur Lösung der gestellten Aufgabe aber auch nicht nötig, da wegen der engen räumlichen Nachbarschaft der Transistoren innerhalb einer Bewerterschaltung AMPL die n-Kanal-Transistoren zueinander gleiche Eigenschaften aufweisen und entsprechend die p-Kanal-Transistoren. Es reicht somit völlig aus, beispielsweise das Ansprechverhalten des einen n-Kanal-Transistors und des einen p-Kanal-Transistors einer Bewerterschaltung AMPL bezüglich des einen elektrischen Potentials VXN zu ermitteln, um damit auch das Ansprechverhalten des anderen n-Kanal-Transistors und des anderen p-Kanal-Transistors bezüglich des einen elektrischen Potentials VXN beurteilen zu können und somit das Ansprechverhalten einer gesamten Bewerterschaltung AMPL. Entsprechendes gilt für das andere elektrische Potential VXP.

Günstig ist es, wenn mit den externen Bitleitungen XB, X̄B̄ verbundene Signalquellen wie z.B. Datenweichen zur Bereitstellung von im Normalbetrieb einzuschreibenden Daten deaktivierbar sind, so daß sie die elektrischen Potentiale VXN,VXP im Testbetrieb nicht beeinflussen. Dabei ist es vorteilhaft, wenn die Signalquellen mittels des Taktsignales Ø (bzw. mittels des dazu komplementären Taktsignales Ø̄) deaktivierbar sind.

In einer Ausführungsform der Erfindung sind die frei wählbaren elektrischen Potentiale VXN,VXP im Halbleiterspeicher selbst erzeugbar, beispielsweise mittels Potential-Generatoren. In einer weiteren Ausführungsform sind sie dem Halbleiterspeicher extern zuführbar. Dies kann beispielsweise über sog. Hilfspads erfolgen oder über Prüfspitzen, die auf den frei wählbaren Potentialen VXN,VXP zugeordneten Leiterbahnen aufgesetzt werden. In beiden Fällen ist der Halbleiterspeicher nach einer Montage in ein Gehäuse vor unberechtigten Manipulationen seitens Dritter geschützt.

Vorteilhaft ist es weiterhin, wenn die Bewerterschaltungen AMPL mittels des Taktsignales Ø deaktivierbar sind im Testbetrieb. Dies minimiert ihren (ohne das Deaktivieren bereits geringen) Einfluß auf die frei wählbaren elektrischen Potentiale VXN,VXP auf den internen Bitleitungen BL, B̄L̄.

Es hat sich auch als vorteilhaft erwiesen, wenn die Werte der beiden elektrischen Potentiale VXN,VXP unabhängig voneinander einstellbar sind.

## Ansprüche

1. Integrierter Halbleiterspeicher vom Typ DRAM
- mit Speicherzellen (MC) und Bewerterschaltungen (AMPL), die über interne Bitleitungen (BL, B̄L̄) miteinander verbunden sind und
- mit wenigstens einem Paar externer Bitleitungen (XB, X̄B̄), die mit den internen Bitleitungen (BL, B̄L̄) über Transfertransistoren (TT) verbunden sind,
**dadurch gekennzeichnet,** daß der Halbleiterspeicher Mittel (TN,TP) enthält zur Verbindung der externen Bitleitungen (XB, X̄B̄) mit wertemäßig frei wählbaren elektrischen Potentialen (VXN,VXP).

2. Integrierter Halbleiterspeicher nach Anspruch 1, **dadurch gekennzeichnet,** daß die Mittel (TN,TP) Transistoren sind, insbesondere vom zueinander komplementären Typ.

3. Integrierter Halbleiterspeicher nach Anspruch 1 oder 2, **dadurch gekennzeichnet,** daß die Mittel (TN,TP) durch ein Taktsignal (∅) steuerbar sind.

4. Integrierter Halbleiterspeicher nach Anspruch 3, **dadurch gekennzeichnet,** daß das Taktsignal in Form zweier zueinander komplementärer Signale (∅, $\overline{∅}$) gegeben ist.

5. Integrierter Halbleiterspeicher nach einem der vorhergehenden Ansprüche, **dadurch gekennzeichnet,** daß mit den externen Bitleitungen (XB, $\overline{XB}$) verbundene Signalquellen deaktivierbar sind.

6. Integrierter Halbleiterspeicher nach Anspruch 5, **dadurch gekennzeichnet,** daß die Signalquellen mittels des Taktsignales (∅, $\overline{∅}$) deaktivierbar sind.

7. Integrierter Halbleiterspeicher nach einem der Ansprüche 2 bis 6, **dadurch gekennzeichnet,** daß die Bewerterschaltungen (AMPL) mittels des Taktsignales (∅) deaktivierbar sind.

8. Integrierter Halbleiterspeicher nach einem der Ansprüche 1 bis 7, **dadurch gekennzeichnet,** daß die frei wählbaren elektrischen Potentiale (VXN,VXP) im Halbleiterspeicher selbst erzeugbar sind.

9. Integrierter Halbleiterspeicher nach einem der Ansprüche 1 bis 7, **dadurch gekennzeichnet,** daß die frei wählbaren elektrischen Potentiale (VXN,VXP) dem Halbleiterspeicher extern zuführbar sind.

10. Integrierter Halbleiterspeicher nach einem der vorhergehenden Ansprüche, **dadurch gekennzeichnet,** daß die Werte der frei wählbaren elektrischen Potentiale (VXN, VXP) unabhängig voneinander einstellbar sind.

11. Verfahren zum Betrieb eines Halbleiterspeichers vom Typ DRAM, **dadurch gekennzeichnet,** daß in einem Testbetrieb in Speicherzellen (MC) Daten gespeichert werden mit Werten elektrischer Potentiale (VXN,VXP), die unterschiedlich sind zu Werten entsprechender elektrischer Potentiale (VSS,VDD) in einem Normalbetrieb, wobei sonstige Teile des Halbleiterspeichers im Testbetrieb mit denselben Signalen und Werten elektrischer Potentiale betrieben werden wie im Normalbetrieb.

12. Verfahren nach Anspruch 11, **dadurch gekennzeichnet,** daß beim Speichern der Daten im Testbetrieb Signalquellen, die mit wenigstens einem Paar externer Bitleitungen (XB, $\overline{XB}$) verbunden sind, mittels eines Taktsignales (∅) deaktiviert werden.

13. Verfahren nach Anspruch 11 oder 12, **dadurch gekennzeichnet,** daß beim Speichern der Daten im Testbetrieb Bewerterschaltungen (AMPL) des Halbleiterspeichers mittels eines Taktsignales (∅) deaktiviert werden.

14. Verfahren nach einem der Ansprüche 11 bis 13, **dadurch gekennzeichnet,** daß die Werte der im Testbetrieb zum Speichern verwendeten elektrischen Potentiale (VXN,VXP) frei wählbar sind.

15. Verfahren nach einem der Ansprüche 11 bis 14, **dadurch gekennzeichnet,** daß die Werte der im Testbetrieb zum Speichern verwendeten elektrischen Potentiale (VXN,VXP) unabhängig voneinander wählbar sind.

16. Verfahren nach einem der Ansprüche 11 bis 15, **dadurch gekennzeichnet,** daß die im Testbetrieb zum Speichern verwendeten elektrischen Potentiale (VXN,VXP) dem Halbleiterspeicher extern zugeführt werden.

17. Verfahren nach einem der Ansprüche 11 bis 15, **dadurch gekennzeichnet,** daß die im Testbetrieb zum Speichern verwendeten elektrischen Potentiale (VXN,VXP) im Halbleiterspeicher selbst erzeugt werden.

89 P 1435E

# FIG 1

# FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-4 502 140 (MOSTEK CORP.) * Spalte 7, Zeile 31 - Spalte 12, Zeile 49; Figur 2 * | 1,3,5,8 ,10-15, 17 | G 11 C 29/00 G 11 C 11/40 |
| A | | 7 | |
| A | IEEE JOURNAL OF SOLID STATE CIRCUITS, Heft 10, Nr. 5, Oktober 1975, Seiten 255-261; R.C. FOSS u.a.: "Peripheral Circuits for One-Transistor Cell MOS RAM's" * Seite 258, rechter Spalte, Zeile 16 - Seite 259, rechter Spalte, Zeile 18; Figur 7 * | 1 | |
| A | EP-A-0 317 012 (PHILIPS GLOEILAMPENFABRIEK) * Spalte 7, Zeile 12 - Spalte 8, Zeile 27; Figuren 1-3 * | 1 | |

**RECHERCHIERTE SACHGEBIETE (Int. Cl.5)**

G 11 C 29/00
G 11 C 11/40
G 11 C 11/41

Der vorliegende Recherchenbericht wurde für alle Patentansprüche erstellt

| Recherchenort | Abschlußdatum der Recherche | Prüfer |
|---|---|---|
| DEN HAAG | 12-02-1990 | DEGRAEVE L.W.G. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument